# EUROPEAN PATENT SPECIFICATION

(11) **EP 0 365 720 B1**
(45) Date of publication and mention of the grant of the patent: **03.04.1996**
(21) Application number: 88309994.7
(22) Date of filing: 24.10.1988
(51) Int. Cl.: G11C 7/00, G11C 16/04, G11C 16/06

(54) **Programmable semiconductor memory**
Programmierbarer Halbleiterspeicher
Mémoire à semi-conducteurs programmable

(43) Date of publication of application: 02.05.1990
(60) Divisional application: 92201954.2
(73) Proprietor: KABUSHIKI KAISHA TOSHIBA, Kawasaki-shi, Kanagawa-ken 210, Tokyo (JP)
(72) Inventor: Masuoka, Fujio c/o Patent Division, 1-1-1, Shibaura Minato-ku Tokyo (JP)
(74) Representative: Freed, Arthur Woolf

(56) References cited:
- EP-A- 0 317 324
- US-A- 4 485 349
- US-A- 4 648 074
- PATENT ABSTRACTS OF JAPAN, vol. 12, no. 86 (P-677)(2933), page 126
- IBM TECHNICAL DISCLOSURE BULLETIN, vol. 27, no. 6, November 1984, pages 3302-3307; New York, US, E. ADLER: "Densely arrayed EEPROM having low-voltage tunnel write"
- INTERNATIONAL ELECTRON DEVICES MEETING, Washington, December 8-10, 1980, pages 602-606; IEEE, New York, US, J. KUPEC et al.: "Triple level polysilicon E2PROM with single transistor per bit"

## Description

This application is related by subject matter to EP-A-0 365 721 entitled "Programmable Semiconductor Memory" filed concurrently herewith.

This invention is applicable to a programmable semiconductor memory using non-volatile transistors as memory cells from which data can be electrically erased. It particularly but not exclusively relates to a non-volatile semiconductor memory in which data stored in a plurality of memory cells may be erased simultaneously, in units of a block, or in units of a column. Data may be written to the memory a cell (or bit) at a time.

A non-volatile transistor memory which permits erasure of data is known as an EPROM (Erasable and Programmable Read Only Memory). An EPROM from which data may be erased electrically is called an E PROM (Electrically Erasable PROM). E PROMs have been developed which permit the simultaneous erasure of data stored in a plurality of memory cells. Such an E PROM is disclosed in "A 128K Flash EEPROM Using Double Polysilicon Technology", pp. 76-77 of "1987 IEEE International Solid State Circuits Conference, Digest of Technical Papers."

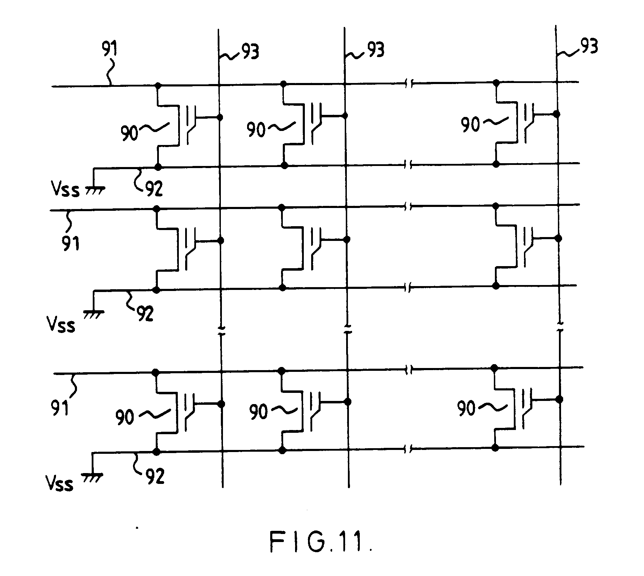

Figure 11 is a circuit diagram depicting a conventional E PROM memory cell array using the cells described in the above-mentioned document. In this Figure, memory cells 90 consist of non-volatile transistors having a floating gate electrode and a control gate electrode. Data erasure may be effected electrically. Memory cells 90 are arranged in a row and column matrix. The drains of each memory cell 90 in a given row of memory cells (which are horizontal as seen in the drawing) are respectively coupled to the same one of bit lines 91. The sources of the memory cells 90 in a given row of memory cells are respectively coupled to the same one of ground lines 92. The control gate electrodes of the memory cells 90 in a given column of memory cells (which are vertical as seen in the drawing) are respectively coupled to the same one of column lines 93. In this memory, data may be read or written by the selective imposition of set voltages on a given bit line 91 and column line 93 to select a particular 1-bit cell. Block data erasure of all the bits can be effected by the simultaneous imposition of a set voltage on all the bit lines 91.

This memory permits large-scale integration of cells since each cell or bit consists of a single non-volatile transistor. However, data erasure may only be effected in the cells simultaneously or in units of a row. It is not possible to effect data erasure in units of a byte, the processing unit for parallel read/write memories.

Another memory wherein non volatile memory cells are arranged in a row and column matrix and wherein the cells in a given column are series connected is disclosed in JP-A-62 219 296,

The prior art does disclose an E PROM which permits data erasure in byte units. Reference is made, for example to "A Million-cycle CMOS 256K EEPROM", pp. 78-79 of "1987 IEEE International Solid-State Circuits Conference, Digest of Technical Papers." However, large-scale integration of cells is not possible with the memory disclosed therein, since each 1-bit memory cell comprises two or four transistors.

US-A-4 648 074 discloses a memory device according to the preamble of claim 1. US-A-4 485 349 discloses use of ground potential to control gates of non-selected floating gate memory cells in a given row line.

According to the invention, there is provided the features of claim 1.

It is an advantage of the described embodiment of the invention that a device to control the operations of a programmable semiconductor memory wherein the reading, writing and electrical erasure of data is effected in 8 bit (1 byte) units is provided.

Another advantage is that a progammable semiconductor memory wherein a high integration density can be achieved by reducing the number of wires and the number of contact is provided.

Another advantage is that a programmable semiconductor memory is provided wherein the reading, writing, and electrical erasure of data in 8 bit (1 byte) units can be achieved.

Yet another advantage is that a programmable semiconductor memory with high integration density is provided wherein the electrical data erasure is made in byte units.

A further advantage is that a programmable semiconductor memory is provided whose manufacturing cost is low.

An embodiment of the invention will now be described, by way of example, with reference to the accompanying drawings, in which:

Figure 1 is a circuit diagram showing the entire configuration, including peripheral circuitry, of an embodiment of an E PROM according to the present invention.

Figure 2 is a circuit diagram showing the detailed configuration of the column decoder/input-output circuit depicted in Figure 1.

Figure 3 is a circuit diagram showing the detailed configuration of the latch circuit depicted in Figure 2.

Figure 4 is a circuit diagram showing the detailed configuration of the sense amplifier depicted in Figure 2.

Figure 5 is a circuit diagram showing the detailed configuration of the data input buffer depicted in Figure 2.

Figure 6 is a circuit diagram showing the detailed configuration of a portion of the selector circuit depicted in Figure 2.

Figure 7 is a table showing the address inputs to the partial selectors of the selector circuit depicted in Figure 2.

Figures 8A and 8B are timing charts associated with writing data to the E PROM depicted in Figure 1.

Figures 9A and 9B are timing charts associated with reading data from the E PROM depicted in Figure 1.

Figure 10 is a timing chart associated with erasing data from the E PROM depicted in Figure 1.

Figure 11 is a circuit diagram of a prior art non-volatile semiconductor memory.

Figure 12 is the circuit diagram of Figure 1 without the associated peripheral circuitry.

Figure 13 is a plan view of a pattern showing the memory cell array of the circuit diagram corresponding to Figure 12.

Figures 14, 15 and 16 are cross-sectional views taken along lines I-I′, II-II′, and III-III′ of Figure 13 respectively.

Figures 17 and 18 are cross-sectional views showing the non-volatile transistors provided with a floating gate electrode and a control gate electrode.

### DETAILED DESCRIPTION OF THE PREFERRED EMBODIMENT

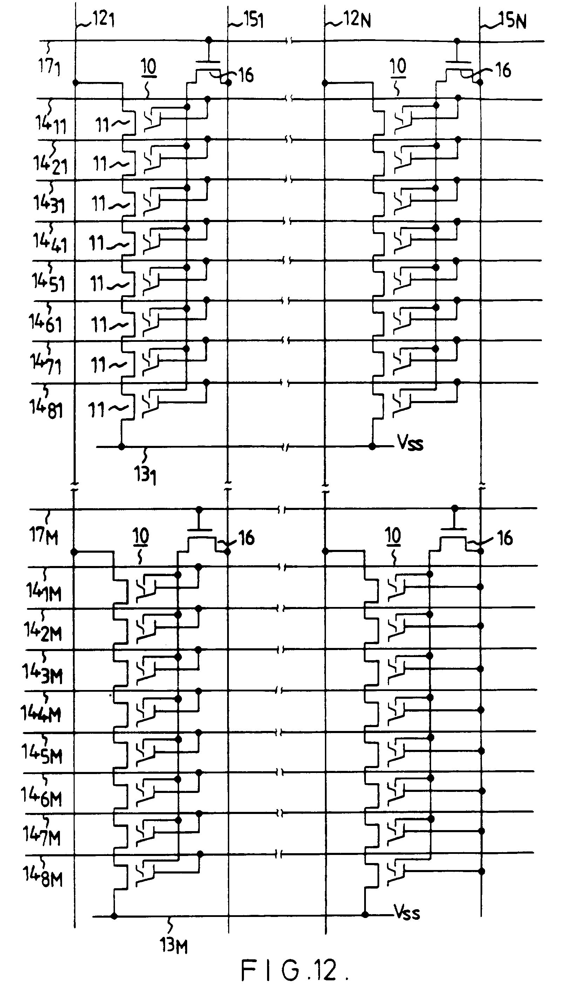

Figure 12 is a circuit diagram of a memory cell array portion in which the present invention is applied to an E PROM (referred to below simply as a "memory"). In the drawing, series circuit units 10 each include eight memory cells 11 connected in series. Each memory cell 11 in each series circuit unit 10 includes a non-volatile transistor having: a source region; a drain region; a floating gate electrode provided in the channel region between the source and drain regions; an erase gate electrode; and a control gate electrode, the latter two gate electrodes arranged so as to overlap the floating gate electrode.

Generally, the present invention may be applied to what may be termed programmable memories. Programmable memory as used herein refers to any kind of semiconductor memory which can be programmed after fabrication or manufacture. It may include, but should not be limited to, non-volatile memories, SRAMs, and DRAMs.

A plurality of these series circuit units 10 are arranged in a matrix fashion. The series circuit units are disposed in rows and columns. As used herein "row" refers to that which extends horizontally or from left to right as viewed in Figure 12. "Column" refers to that which extends vertically or from top to bottom as viewed in Figure 12. For clarity in the subsequent discussion, it should be noted that each row of series circuit units in Figure 12 includes eight rows of memory cells, the control gates of the memory cells disposed in a given row of memory cells being coupled to the same one of row lines 14. Although these terms have been defined for clarity of description, they should not be read to limit in any way the scope of the invention, but rather to facilitate understanding.

Each series circuit unit 10 has one end coupled to one of bit lines 12₁, . . .12_{N}, with each of the series circuit units in a given column of series circuit units being coupled to the same bit line. The other end of each series circuit unit 10 is coupled to one of ground lines 13₁,. . .13_{N}, with each of the series circuit units in a given row of series circuit units being coupled to the same ground line. A potential difference of 0 V is maintained across each of the ground lines 13. The control gate electrodes of each of the eight memory cells 11 in a series circuit unit 10 are coupled to a respective one of row lines 14. Each row of series circuit units has associated with it eight row lines 14₁ . . .14₈, with the memory cells in a given row of memory cells being coupled to the same row line. In eacn series circuit unit 10, the erase gate electrodes of the eight memory cells 11 are connected to each other. These connected erase gate electrodes are coupled to one of erase lines 15₁, . . .15_{N} through a switching transistor 16. The series circuit units in a given column of series circuit units are coupled to the same erase line through switching transistors, a single switching transistor being provided for each series circuit unit. The control gate electrodes of the switching transistors 16 are coupled to one of erase selection lines 17₁, . . .17_{M}, with the control gate electrodes of the switching transistors in a given row of series circuit units being coupled to the same erase selection line.

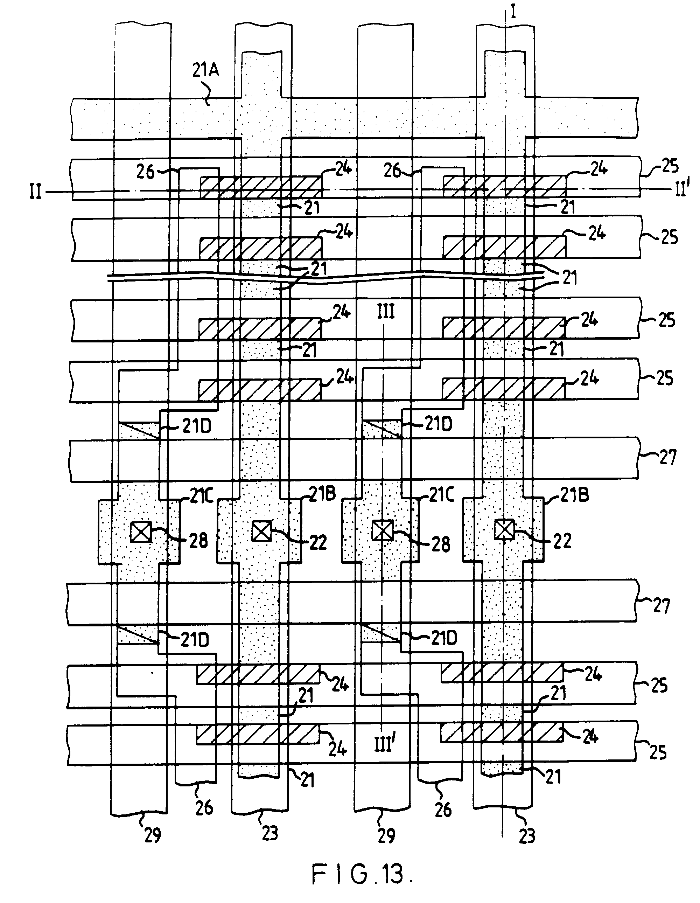

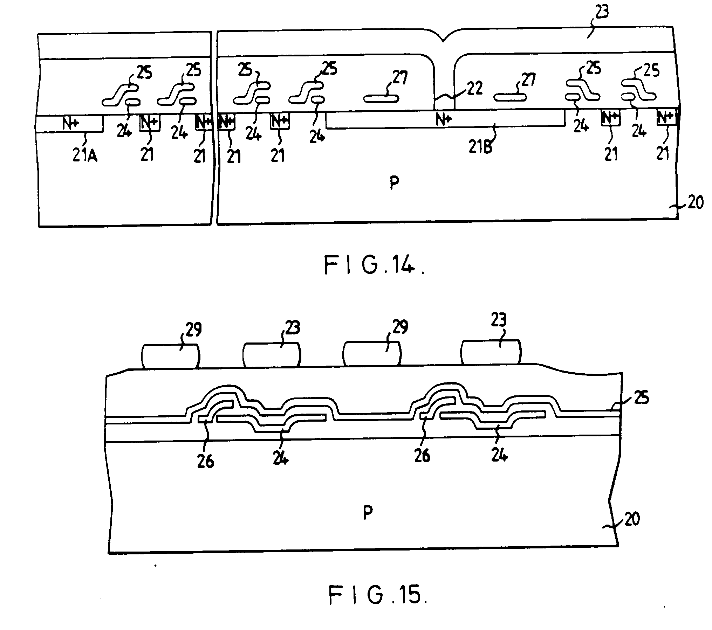

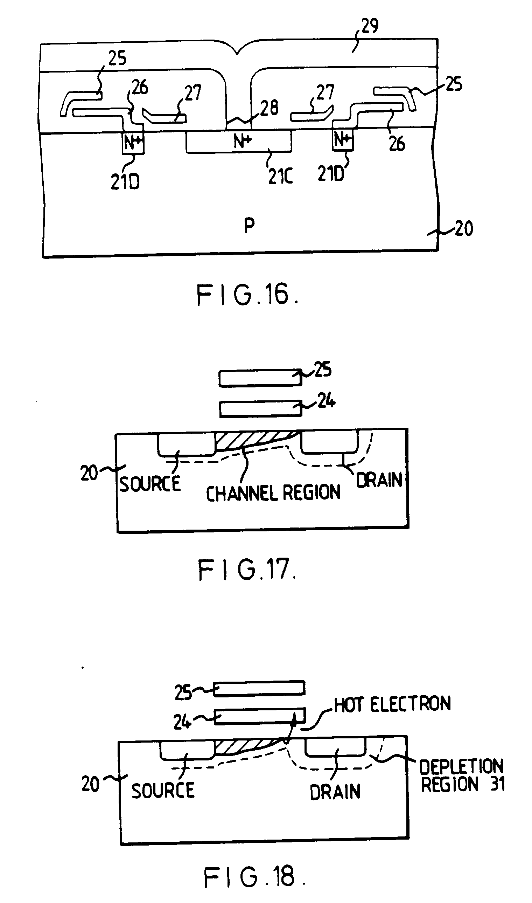

Figure 13 is a pian view corresponding to the structure of the memory cell array circuit shown in Figure 12 when such a memory is actually provided on a semiconductor chip. Figure 14 is a cross-sectional view along the line I-I′ in Figure 13. Figure 15 is a cross-sectional view along the line II-II′ in Figure 13. Figure 16 is a cross-sectional view along the line III-III' in Figure 13.

A P-type silicon semiconductor substrate is used as the substrate 20 in the memory of this embodiment. Separate N⁺ type regions 21, providing the source and drain regions of the eight memory cells 11 in each series circuit unit 10, are formed in the surface region of the substrate 20. N⁺ regions 21A and 21B, positioned in the uppermost and central portions of Figure 13 respectively, are common to neighboring series circuit units 10. N⁺ region 21A serves as a ground line 13. Metal leads 23, made for example of aluminum, are connected to N⁺ regions 21B through contact holes 22 and serve as the bit lines 12. Electrodes 24, made of a first polycrystalline silicon layer and put in a floating electrical state, are formed between adjacent N⁺ regions 21, insulated therefrom by an insulating layer. Electrodes 24 are the floating gate electrodes of the various memory cells 11. Electrodes 25, made of a third polycrystalline silicon layer, are formed over the sets of electrodes 24 that are disposed horizontally in Figure 13, insulated therefrom by an insulating layer. Electrodes 25 are the control gate electrodes of the memory cell 11 and serve as the column lines 14. Electrodes 26, made of a second polycrystalline silicon layer, are formed between adjacent series circuits disposed in different columns, and partially overlap electrodes 24, insulated therefrom by an insulating layer. Electrodes 26 are the common erase gate electrodes of the various memory cells 11 in the series circuit units.

N⁺ regions 21C are formed between adjacent N⁺ regions 21B. A pair of N⁺ regions 21D are also formed separate from N⁺ regions 21C. N⁺ regions 21C and 21D are the source and drain regions of switching transistor 16. Electrodes 27, made of the third polycrystalline silicon layer, are formed between these source and drain regions, insulated therefrom by an insulating layer. Electrodes 27 are the control gate electrodes of transistors 16 and serve as the erase selection lines 17. Electrodes 26, the common erase gate electrodes, are connected to N⁺ regions 21D via a direct contact portion and metal leads 29, of, for example, aluminum, are connected to N⁺ regions 21C via contact holes 28. Metal leads 29 serve as erase lines 15.

Thus, the memory is a matrix of series circuit units 10, each of which comprises eight series connected memory cells 11. One end each of each series circuit unit 10 is connected to a bit line 12, embodied in metal lead 23, and the other end is connected to a ground line 13, embodied in N⁺ region 21A. The control gate electrodes of the various memory cells 11 are connected to row lines 14, embodied in electrodes 25. The erase gate electrodes of each memory cell in a series circuit unit are commonly connected and coupled to erase lines 15 via transistors 16. The conduction of transistors 16 is controlled by signals from the corresponding erase selection line 17.

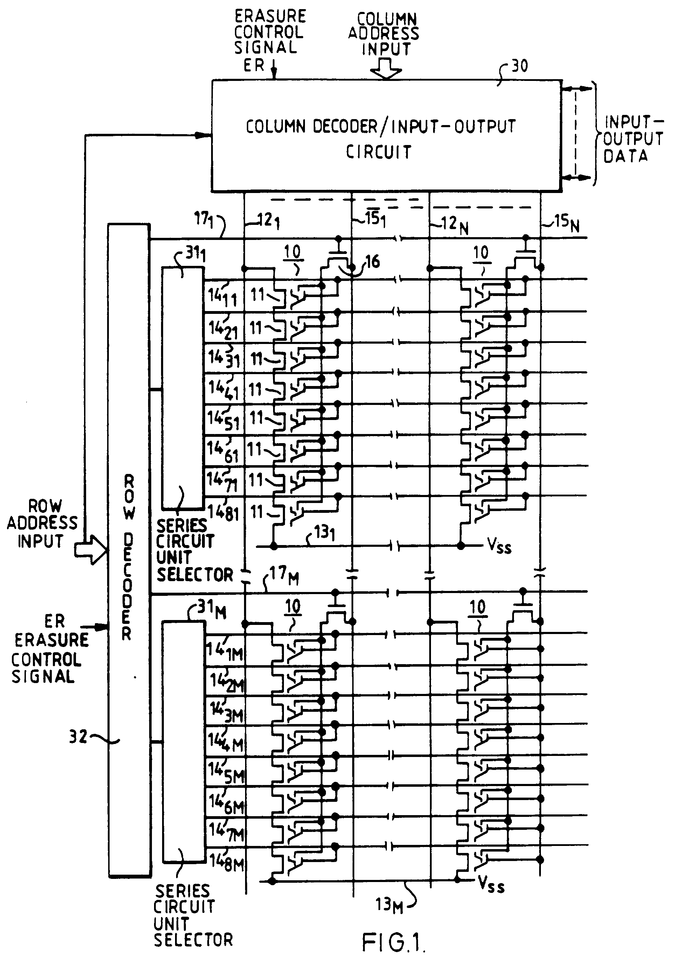

Figure 1 is a diagram showing the overall configuration of an E PROM according to one embodiment of the present invention. N bit lines 12 and N erase lines 15 are coupled to column decoder/input-output circuit 30 to which an erase control signal ER and a column address input are input. Parts of the row address inputs, discussed later, are input to column decoder/input-output circuit 30, and 8-bit input/output data is input to and output from circuit 30. The detailed configuration of column decoder/input-output circuit 30 will be described below.

Eight row lines 14 are coupled to each of the series circuit unit selectors 31₁ to 31_{M}. Series circuit unit selectors 31 and M erase selection lines 17 are coupled to row decoder 32, to which row address input and erase control signal ER are input. Row decoder 32 outputs a selection signal to one series circuit unit selector 31 in response to a row address input, and selectively outputs a high voltage to one of M erase selection lines 17 in response to row address input during data erasure.

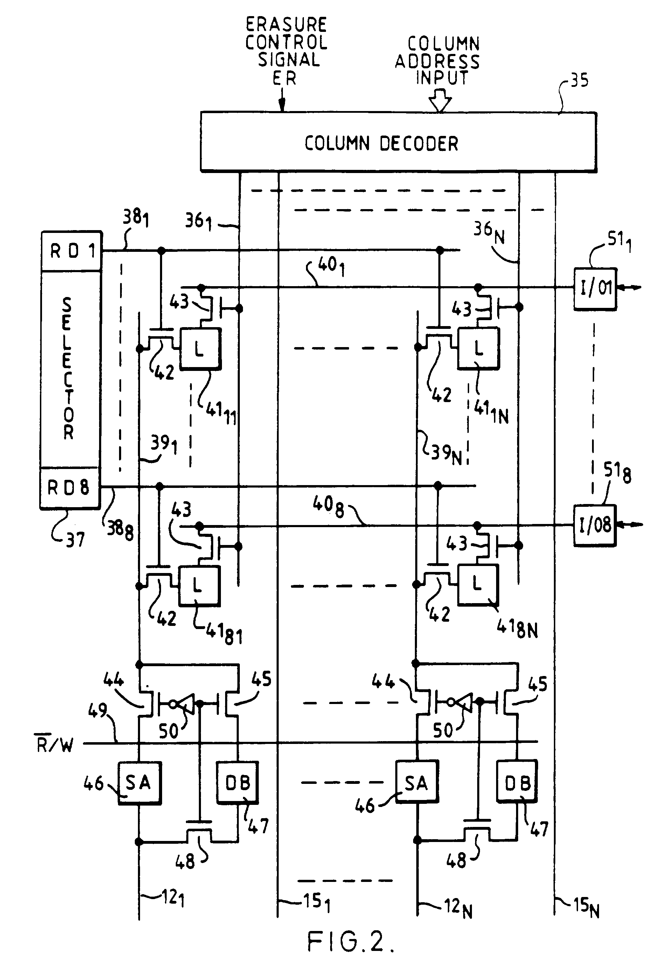

Figure 2 is a circuit diagram showing the internal configuration of column decoder/input-output circuit 30. In Figure 2, reference numeral 35 denotes a column decoder to which a column address input and an erase control signal ER are input. Erase lines 15₁ to 15_{N} and control lines 36₁ to 36_{N} are coupled to column decoder 35. Column decoder 35 selects one of control lines 36₁ to 36_{N} in response to the column address input during data writing and data reading and outputs a high voltage thereto. Decoder 35 selects one of erase lines 15₁ to 15_{N} during data erasure and similarly outputs a high voltage thereto.

Reference numeral 37 denotes a selector, to which parts of the row address inputs (e.g., 3-bit addresses A₁, A₂, A₃) are input. Selector 37 has eight partial selectors RD1 - RD8 and selects one of control lines 38₁ to 38_{N} according to an input address, setting it to a high potential.

Reference numerals 39₁ to 39_{N} denote first data lines, and reference numerals 40₁ to 40₈ denote second data lines. Latch circuits 41₁₁,.., 41_{1N} to 41₈₁,.., 41_{8N} for latching 1-bit data are provided at the respective intersections of the first and second data lines. The eight latch circuits disposed in a given column are coupled to the same first data line 39 through respective data transfer MOS transistors 42, a single transistor 42 being associated with each latch circuit 41. The N latch circuits disposed in a given row are coupled to the same second data line 40 through respective data transfer MOS transistors 43, a single transistor 43 being associated with each latch circuit 41. The gates of the N transistors 42 disposed in the same row are coupled to the corresponding one of control lines 38₁ to 38₈ and the gates of the eight transistors 43 disposed in the same column are coupled to the corresponding one of control lines 36₁ to 36_{N}.

Associated with each first data line 39 are two additional data transfer MOS transistors 44, 45. One terminal of both transistors 44, 45 is coupled to the associated data line 39. The remaining terminal of transistor 44 is coupled to the corresponding one of the bit lines 12₁ to 12_{N} through a sense amplifier 46 while the remaining terminal of transistor 45 is coupled to the corresponding bit line through data input buffer (DB) 47 and data transfer MOS transistor 48, respectively. The gates of MOS transistors 45, 48 are coupled to control line 49, to which a read/write control signal R/W, set to a low potential during data reading and to a high potential during data writing, is applied. The gates of MOS transistors 44 are coupled to control line 49 through inverters 50, respectively. Data input/output circuits (I/01 to I/08) 51₁ to 51₈ are coupled to second data lines 40₁ to 40₈, respectively.

In the column decoder/input-output circuit 30 configured as described above, eight latch circuits 41 are provided for each of the N bit lines 12. A sense amplifier 46 and a data input buffer (DB) 47 are also provided for each bit line 12. The MOS transistors are all N-type.

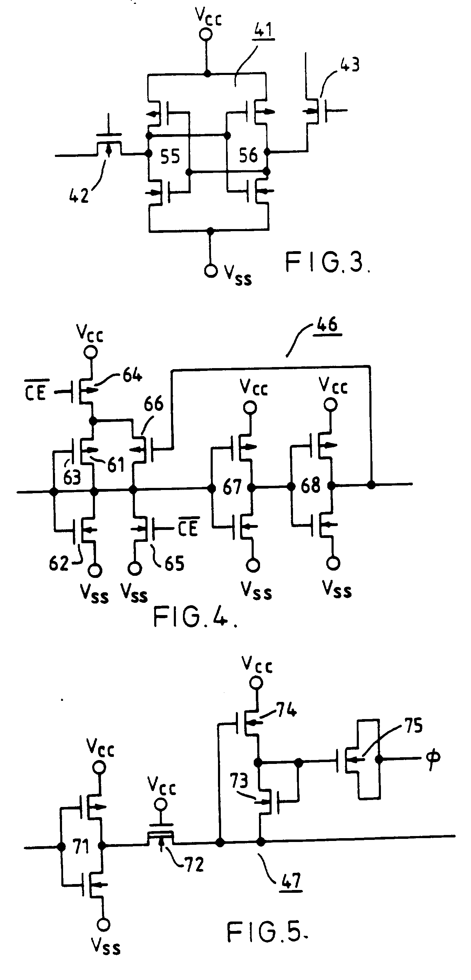

Figure 3 is a circuit diagram showing the detailed configuration of a latch circuit 41 schematically shown in Figure 2. Latch circuit 41 is formed by cross-connecting the input and the output terminals of two CMOS inverters 55 and 56, each inverter having P-type and N-type MOS transistors. One terminal of the data transfer MOS transistors 42 is coupled to the output terminal of inverters 55 and one terminal of data transfer MOS transistors 43 is coupled to the output terminal of inverters 56.

Figure 4 is a circuit diagram showing the detailed configuration of sense amplifier 46 schematically shown in Figure 2. Sense amplifier 46 may be activated by a chip enable control signal CE and includes a CMOS inverter 63 having a P-type MOS transistor 61 and an N-type MOS transistor 62 arranged such that the input and output terminals of the inverter are shortcircuited. P-type MOS transistor 64 is coupled between inverter 63 and power source Vcc and chip enable control signal CE is input to the gate thereof. N-channel MOS transistor 65 is coupled between the output terminal of CMOS inverter 63 and reference power source Vss and chip enable control signal CE is input to the gate thereof. P-type MOS transistor 66 is coupled between the output of CMOS inverter 63 and a junction between inverter 63 and MOS transistor 64. Two CMOS inverters 67, 68 are coupled in cascade to the output of inverter 63. The output of inverter 68 is transmitted as a sense amplifier output to corresponding data line 39 through MOS transistor 44 (Figure 2), and is also fed back to the gate of MOS transistor 66.

The sense amplifier configured as described above is activated in such a manner that transistor 64 is turned on and transistor 65 is turned off when chip enable control signal CE is set to a low-level potential in order to amplify the potential of corresponding bit line 12. Since the input and output terminals of CMOS inverter 63 are shortcircuited, its input terminal potential, i.e., the bit line potential is set, for example, to 1 V when Vcc is, for example, 5 V.

Figure 5 is a circuit diagram showing the detailed configuration of the data input buffer 47 schematically shown in Figure 2. Data input buffer 47 includes a CMOS inverter 71 and a depression type N-type MOS transistor 72, the first terminal of which is coupled to the output terminal of inverter 71. The voltage Vcc is applied to the gate of transistor 72. Two N-type MOS transistors 73, 74 are coupled in series between the second terminal of MOS transistor 72 and power source Vcc. N-type MOS transistor 75 is arranged such that its source and drain terminals are coupled together. A pulse signal 0 is input thereto to substantially produce a capacitor-like operation. The gates of transistors 73 and 75 are coupled to a junction between series-coupled transistors 73 and 74. The gate of transistor 74 is connected to the second terminal of MOS transistor 72. The data input buffer constructed as described above has a voltage rising function using a pulse signal.

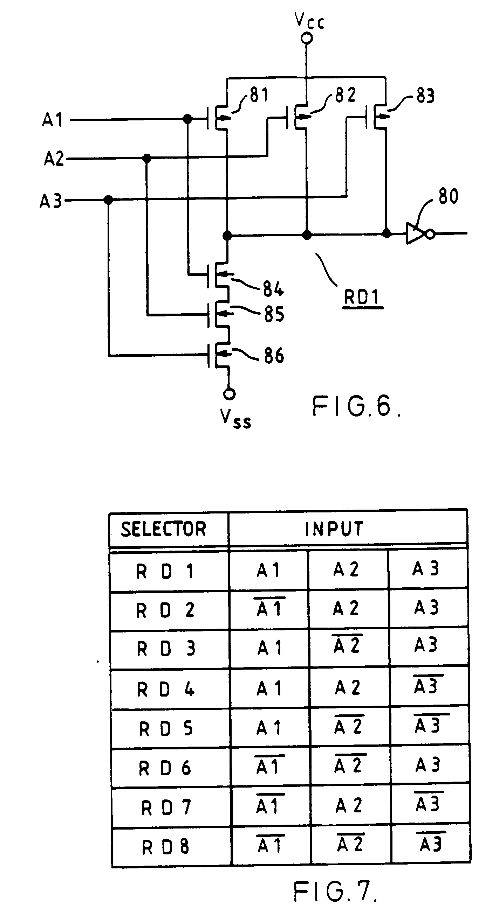

Figure 6 is a circuit diagram showing the detailed configuration of partial selector RD1 of the 8 partial selectors of selector 37 schematically shown in Figure 2. Partial selector RD1 has three P-type MOS transistors 81, 82, 83 coupled in parallel between power source Vcc and the input terminal of inverter 80. Three N-type MOS transistors 84, 85, 86 are coupled in series between the input terminal of inverter 80 and reference power source Vss. Bit A1 of the 3-bit row address input is input to the gates of transistors 81 and 84, A2 is input to the gates of transistors 82 and 85, and A3 is input to the gates of transistors 83 and 86. In partial selector RD1 constructed as described above, when the 3-bit address inputs A1, A2, A3 are all set to a high potential and the three N-type MOS transistors 84, 85, 86 are all turned on, the input terminal of inverter 80 is discharged to Vss. Thus, the output signal of inverter 80 becomes high level, thereby selecting the corresponding control line 38.

The remaining partial selectors of selector 37 are similarly constructed, but the 3-bit address inputs differ from those of RD1. Figure 7 illustrates the address inputs of the eight partial selectors RD1 to RD8.

The detailed operation of the memory constructed as described above will now be described. It should be understood that although the memory operations described below illustrate a particular sequence, the invention is not limited in this respect. Sequence as used herein refers to any predetermined order.

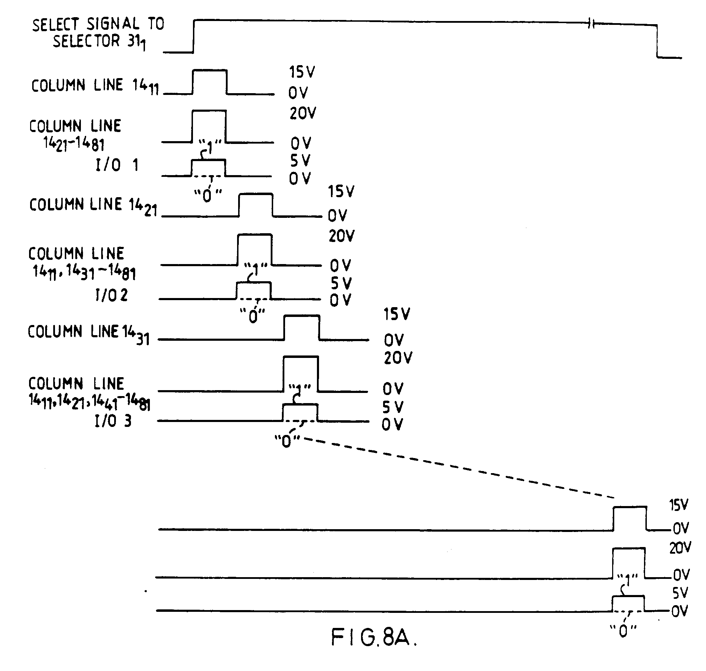

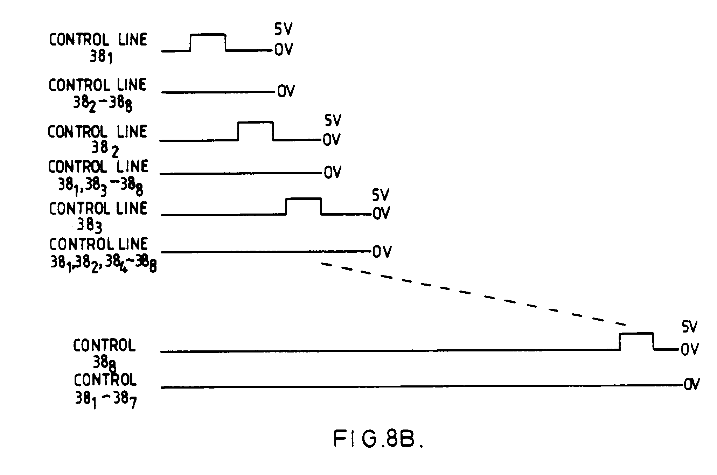

First, the operation of the memory during data writing will be described with reference to the timing charts of Figures 8A and 8B. Data is written by selecting one series circuit unit 10 and sequentially writing the data in the eight cells of the selected series circuit unit. Each cell of the selected series circuit unit is sequentially processed with a potential difference of 15 V imposed on the row line coupled to the control gate electrode of the cell being processed and a potential difference of 20 V imposed on the seven remaining row lines.

Suppose, for example, that the selected series circuit unit is coupled to bit line 12₁ and the eight row lines 14₁₁ to 14₈₁. A selection signal is output from row decoder 32 to series circuit selector 31₁, thereby selecting series circuit selector 31₁. In addition, a selection signal is output from column decoder 35 in column decoder/input-output circuit 30 to control line 36₁, and the eight transistors 43 whose gates are coupled to control line 36₁ are turned on. Then, data from second data lines 40₁ to 40₈ may be input to the eight latch circuits 41₁₁ to 41₈₁ disposed as shown in Figure 2. Under the control of the output of series circuit selector 31, a voltage of 15 V is imposed on row line 14₁₁ and a voltage of 20 V is imposed on the seven remaining row lines 41₂₁ to 41₈₁. At this time, all other row lines are maintained at 0 V. Under the control of selector 37, a voltage of 5 V is imposed on control line 38₁ and a voltage of 0 V is applied to the seven remaining control lines 38₂ to 38₈. Thus, the transistor 42 whose gate is coupled to control line 38₁ (maintained at 5V) is turned on, and the data latched in latch circuit 41₁₁ can be output to first data line 39₁. At this point, write data input from data input/output circuit 51₁ is transmitted to first data line 39₁ through second data line 40₁, transistor 43, latch circuit 41₁₁ and transistor 42. As noted above, signal R/W of control line 49 is set to a high potential during data writing, and thus transistors 45 and 48 are turned on. Write data transmitted to data line 39₁ may then be output to bit line 12₁ through data input buffer 47. The voltage of bit line 12 is maintained at one of two different voltages by the data input buffer 47 shown in Figure 5 in accordance with the data being written. When high-level data is written, it may be set to 10 V, for example, while when low-level data is written, it may be set to 0 V. At this time, all other bit lines are maintained at 0 V.

The seven memory cells 11 whose control gate electrodes are supplied with the voltage of 20 V operate as triodes (non-saturation operation). In this operation a channel region is formed between the source and drain regions, as shown in Figure 17.

The voltage between bit line 12₁ and ground line 13₁ is imposed across the source and drain of the selected cell, connected to column line 14₁₁. If bit line 12₁ is maintained at 10 V , electrons travel from the selected cell's source region to its drain region. A concentrated electric field, particularly in the depletion layer formed in the vicinity of the drain region, accelerates the electrons and imparts to them sufficient energy to cross the energy barrier of the insulating film from the surface of substrate 20, as shown in Figure 18. These electrons are called "hot electrons" and they are drawn to the selected cell's control gate electrode, which is set at the high voltage of 15 V. These hot electrons jump to and are captured by the floating gate electrode. As a result, the floating gate electrode of the selected cell becomes negatively charged and the threshold voltage rises to a high value.

If a voltage of 0 V is applied to bit line 12₁, the hot electrons are not generated and the threshold voltage remains in its original low state. Data may be written one cell at a time in this manner.

Next, output from series circuit selector 31 causes a voltage of 15 V to be imposed on row line 14₂₁ and a voltage of 20 V to be imposed on the seven remaining row lines. Likewise, output from selector 37 causes a voltage of 5 V to be imposed on control line 38₂ and 0 V to be imposed on the seven remaining control lines. Thus, the transistor 42, whose gate is coupled to control line 38₂ is turned on, and the data latched in latch circuit 41₂₁ may be output to first data line 39₁. At this time, data input from data input/output circuit 51₂(I/02) is transmitted to first data line 39₁ through second data line 40₂, transistor 43, latch circuit 41₂₁ and transistor 42. Thus, data may be written to the memory cell connected to row line 14₂₁. In a similar manner, data may be sequentially written to each of the remaining cells 11 in the selected series circuit unit 10.

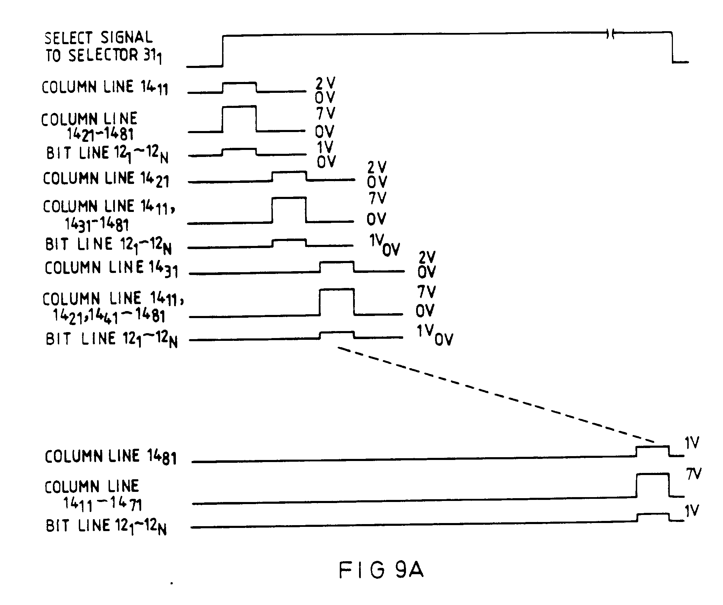

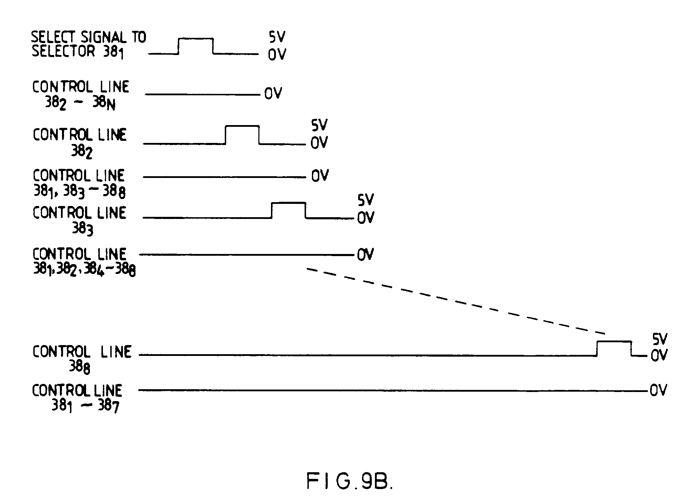

Next, the data reading operation will be described with reference to the timing charts of Figures 9A and 9B. During data reading, the N memory cells 11 disposed in a given row of memory cells are simultaneously selected for reading, the selected N cells being read in parallel. Under the control of a series circuit selector 31, a voltage of 2 V is applied to the row line coupled to the control gates of then selected cells, and a voltage of 7 V is applied to the seven remaining row lines. The other row lines are all maintained at 0 V.

Suppose, for example, the selected series circuit units are coupled to the eight row lines 14₁₁ to 14₈₁. A voltage of 2 V is initially applied only to row line 14₁₁, and a voltage of 7 V is applied to the seven remaining row lines 14₂₁ to 14₈₁. The threshold voltages of the selected memory cells 11 have been set in accordance with the data written to them during the data writing operation. The voltage of 2 V is, for example, higher than the low threshold voltage of those cells which have had data erased and lower than the high threshold voltage after high-level data is written. The voltage of 7 V is sufficiently higher than the high threshold voltage after high-level data is written. Therefore, applying the described voltages to the eight row lines 14₁₁ to 14₈₁ has the effect of turning on the memory cells whose control gate electrodes are coupled to the potential difference of 7 V, namely those cells on row lines 14₂₁-₈₁. However, the ON or OFF state of the selected cells whose control gate electrodes are coupled to column line 14₁₁, is determined by their threshold voltage, which as noted above, is set during the data write mode.

Sense amplifier 46 coupled to bit lines 12₁ to 12_{N} is activated during data reading, and the potential of the corresponding bit line 12 is set to the reading voltage, for example, of 1 V by sense amplifier 46. Cells in the row of memory cells which is being processed that have a low threshold voltage (i.e. have low-level data written therein) will be turned on by the voltage of row line 14₁₁ and thus the read voltage of the corresponding bit line 12 will be discharged to ground level line 13, through the corresponding series circuit unit. If, however, the cell has a high threshold voltage (i.e. has a high-level data written therein), it will remain off despite the imposition of the voltage of row lines 14₁₁ and the read voltage of the corresponding bit line 12 will not be discharged through the corresponding series circuit unit. Thus, the voltages of the N bit lines 12₁ to 12_{N} are dependent upon whether the threshold voltage of each of the selected cells is high or low, and amplification of these potential differences by sense amplifiers 46 makes it possible to determine whether high or low-level data is present on the associated bit line. Since signal R/W of signal line 49 is set to a low potential during data reading, the transistors 44 of Figure 2 are turned on. Thus, the reading data is amplified by sense amplifier 46 and then transmitted in parallel to the N first data lines 39₁ to 39_{N}.

Under the control of selector 37, a voltage of 5 V is applied to control line 38₁ and 0 V is applied to the seven remaining control lines. Thus, transistors 42 whose gates are coupled to control line 38₁ (maintained at 5 V), are turned on, and the N bits of data transmitted to first data lines 39₁ to 39_{N} are latched in parallel in latch circuits 41₁₁ to 41_{1N}, respectively.

Next, under the control of series circuit selector 31, a voltage of 2 V is applied to row line 14₂₁ and a voltage of 7 V is applied to the remaining seven row lines. Thus, data may be read from the N cells coupled to row line 14₂₁ in a manner similar to that described above, amplified by sense amplifiers 46, determined to be high- or low-level data, and transmitted to data lines 39₁ to 39_{N} respectively. Under the control of selector 37, a voltage of 5 V is applied to control line 38₂ and O V is applied to the seven remaining control lines. Thus, transistors 42, whose gates are coupled to control line 38₂ (maintained at 5 V), are turned on, and the data transmitted to the first data lines 39₁ to 39_{N} is latched in parallel in the N latch circuits 41₂₁ to 41_{2N} disposed in the same row. In a similar manner, data is sequentially read from the cells 11 in similarly processed N series circuit units 10, and transferred to latch circuits 41.

After eight bits (1 byte) of data from each of the series circuit units 10 in a given row of circuit units are latched in the latch circuits, a seiection signal is output to control line 36₁ by the output of decoder 35, and the eight transistors 43, whose gates are coupled to control line 36₁, are turned on. Thus, the data latched in latch circuits 41₁₁ to 41₈₁, disposed as shown in Figure 2, are output in parallel to the eight second data lines 40₁ to 40₈, and output externally in parallel through data input/output circuits 51₁ to 51₈ (I/01 to I/08). Next, the selection signal is output to control line 36₂, and transistors 43, whose gates are coupled to control line 36₂, are turned on. Thus, the data latched in latch circuits 41₁₂ to 41₈₂ disposed as shown in Figure 2 , is output in parallel to second data lines 40₁ to 40₈, and output externally in parallel through data input/output circuits 51₁ to 51₈ (I/01 to I/08).

Thus, data stored in the memory cells is sequentially output in eight bit (1 byte) units. Data may be read out in parallel from N series circuit units 10 during data reading. The reading time required when the data is read into latch circuits 41 from series circuit units 10 according to the present invention can be shortened by a factor of 1/N as compared with the memory of the prior art. As a result, even through the data is read in parallel at 8-bit (1 byte) units only after it has been latched in latch circuits 41, the overall data reading rate can be accelerated.

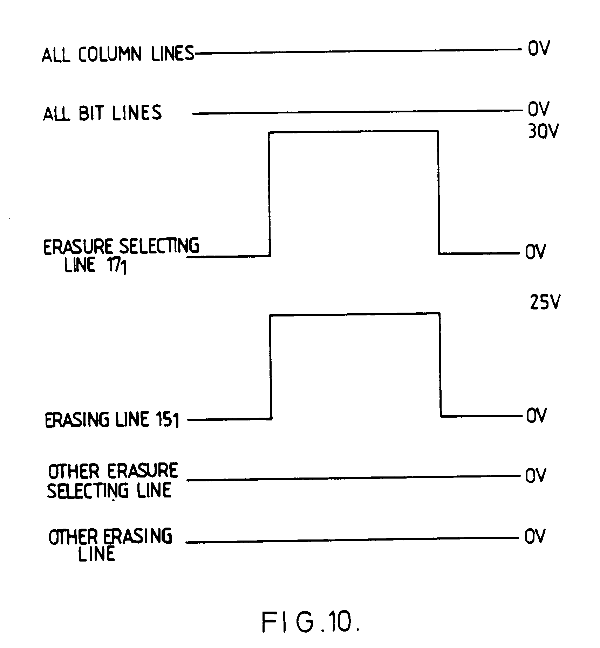

Finally, data erasure will be described with reference to the timing chart of Figure 10. Each row line 14 and bit line 12 is maintained at 0 V during data erasure. A high voltage of 30 V is applied to the erase selecting line 17 coupled to the series circuit unit 10 to be erased. A high voltage of 25 V is applied to erase line 15 coupled to the series circuit unit 10 to be erased. In the example of Figure 10, the series circuit unit 10 to be erased is coupled to bit line 12₁ and the eight row lines 14₁₁ to 14₈₁. Thus, the transistors 16 coupled to the series circuit units 10 disposed in the same row containing the series circuit unit to be erased are turned on. The high voltage of erase line 15, however, is applied only to the common erase gate electrode of the series circuit unit 10 coupled to erase line 15, which is maintained at the high voltage of 25 V. Thus, an electric field emission occurs between the floating gate and erase gate electrodes of the eight cells 11 in the selected series circuit unit 10, and electrons stored in the floating gate electrodes are discharged to the erase gate electrodes. Consequently, the threshold voltages of the cells return to a low-level state, and eight bits of data are erased, i.e., byte erasure is effected.

It is also possible to effect erasure of the data stored in each memory bit simultaneously. In this instance, row decoder 32 and column decoder 35 may be configured so that a high voltage of 30 V is applied to each erase selecting line 17 and a high voltage of 25 V is applied to each erase line 15. Data may also be erased in bit line units.

Thus, the memory of the above-described embodiment permits reading and writing of data in units of 8 bits (1 byte) and electrical data erasure in byte units. Furthermore, one can look to large-scale integration, since the memory cell array includes only one non-volatile transistor for each memory cell. In contrast, conventional memories which permit electrical data erasure in byte units require each bit to comprise two or four transistors and are therefore unable to increase cell integration density. It is only possible to achieve a memory capacity of around 256 K bits in such a conventional memory. With the embodiment described above, however, since 1 bit comprises 1 transistor, it is possible to produce a memory with a degree of integration that is the same or better than that of the block erasure type memory illustrated in Figure 11. Specifically, the above-described embodiment requires the provision of one switching transistor for every eight memory cells 11 and therefore needs 1.125 transistors per bit, or 0.125 more transistors per bit than the memory of Figure 11. However, the block erasure type memory of Figure 11 requires formation of a contact for each bit, in order to connect cells to corresponding bit lines. The memory of the present embodiment only needs one contact for every eight cells and so permits an improvement in the degree of integration.

This invention is not limited to the embodiment described above but may be modified in a variety of ways. For example, although description was given above with reference to the case where data erasure is effected in byte units, it is also possible to effect block erasure of data from all cells, as in conventional memories, by the simultaneous imposition of a voltage of 30 V on all the erase selection lines 17 and a voltage of 25 V on all the erase lines 15 in data erasure.

Description was given with respect to the case where a read voltage of 1 V is imposed on bit lines 12 at times of data reading but it is preferable to make this read voltage as low as possible in order to suppress the phenomenon of so-called soft write (weak write-in occurring in read mode).

Further, although the electrodes 25 in Figure 13 that are used as cell control electrodes and column lines 14 were described as being made of polycrystalline silicon, they may also be made of a high melting point metal silicide, such as titanium silicide or molybdenum silicide, etc., or by another high melting point metal.

In the memory of the above-described embodiments, data can be erased in the multiple bit units, and data can be read at high speed in multiple bit units. Further, a memory cell array may be comprised of memory cells which comprise a single nonvolatile transistor, latch circuits 41 for use in reading data in parallel may be as many as N x 8, and those for an overhead may be extremely less as compared with the memory array section. Thus, the circuit of the memory of this embodiment, the memory cells can be highly integrated.

While the foregoing description is directed to a presently preferred embodiment, it will be obvious to one of ordinary skill that various modifications may be made without departing from the scope of the invention which is to be limited only by the appended claims.

While the number of series memory cells 11 has been shown in the embodiment of figure 1 as 8, this is not to be construed as limitative and other numbers may be so connected, for example, 4,16 or 32 memory cells may be connected (in general 2ⁿ, where n is an integer greater than or equal to one).

## Claims

1. A programmable semiconductor memory comprising:
a plurality of circuit units (10) arranged in a row and column matrix, each circuit unit (10) comprising a plurality of memory cells (11) connected in series, each memory cell (11) comprising a non-volatile transistor;
a plurality of bit lines (12, to 12_{N}) arranged such that one end of each circuit unit (10) is coupled to one of the bit lines, and the circuit units in a given column of said matrix are coupled to the same bit line;
a plurality of row lines (14 to 14_{M}) arranged such that memory cells in a given circuit unit are coupled with their gates to different row lines and the respective memory cells in the circuit units coupled to different bit lines are coupled with their gates to the same row line;
addressing means coupled to the memory cells (11) for sequentially supplying address data to the memory cells (11); and
decoding means (30, 32, 35) responsive to the address data for selecting a memory cell (11) in one of said circuit units (10) by applying voltages to said row lines (14) and said bit lines (12), said decoding means including row decoding means (31, 32) responsive to the address data for applying a first voltage to the row line (14) coupled to the selected cell (11) of said one of said circuit units (10), a second voltage different from the first voltage to the row lines coupled to the unselected memory cells (11) of said one of said circuit units (10), characterised in that said row decoding means (31) applies a ground voltage different from said first and second voltages to all other row lines (14).

2. A programmable semiconductor memory according to Claim 1, in which the transistor of each memory cell (11) has a floating gate electrode (24), a control gate electrode (25) and an erase gate electrode (26).

3. A programmable semiconductor memory according to Claim 2, in which the erase gate electrodes (26) of the memory cells (11) in a given circuit unit (10) are coupled together, said memory further comprising a plurality of erase lines (15), the coupled erase gate of electrodes (26) of each circuit unit (10) in a given column of circuit units (10) being coupled to the same erase line (15).

4. A programmable semiconductor memory as claimed in claim 3, further comprising switching means (16) connected between the coupled erase gate electrodes (26) of each circuit unit (10) and the corresponding erase line (15) to effect selective conduction control.

5. A programmable semiconductor memory as claimed in claim 4, wherein the decoding means (30, 32, 35) is responsive to the addressing means for selectively applying predetermined voltages to said plurality of erase lines (15) in order to erase data from the memory cells (11).

6. A programmable semiconductor memory according to claim 4 or claim 5, wherein said switching means (16) comprises a switching transistor (16).

7. A programmable semiconductor memory according to claim 6, further comprising:
a plurality of erase selection lines (17), the control gate electrodes (25) of the switching transistors corresponding to the circuit units disposed in the same row being coupled to the same erase selection line (17).

8. A programmable semiconductor memory according to claim 7, wherein:
said decoding means (30, 32, 35) applies a first predetermined voltage to an addressed erase line (15) and a second predetermined voltage to an addressed erase selection line (17), said second predetermined voltage activating said switching transistors coupled to said addressed erase selection line (17) so as to effect data erasure in a particular series circuit unit (10) through the applicaton of the first predetermined voltage to the coupled erase gate electrodes (26) of the particular circuit unit (10).

9. A programmable semiconductor memory according to claim 7, wherein:
said decoding means (30, 32, 35) applies a first predetermined voltage to an addressed erase line (15) and a second predetermined voltage to each of said plurality of erase selection lines (17), said second predetermined voltage activating the switching transistors coupled to the erase selection lines (17) so as to effect data erasure in the particular column of series circuit units (10) coupled to both the addressed erase line (15) and the activated switching transistors through the application of the first predetermined voltage to the coupled erase gate electrodes (26) of each circuit unit (10) in said particular column.

10. A programmable semiconductor memory according to claim 7, wherein:
said decoding means (30 32, 35) applies a first predetermined voltage to each of said plurality of erase lines (15) and a second predetermined voltage to each of said plurality of erase selection lines (17), said second predetermined voltage activating the switching transistors coupled to the erase selection lines (17) so as to effect data erasure in every circuit unit (10) through the application of the first predetermined voltage to the coupled erase gate electrodes (16) of the circuit units (10).

11. A programmable semiconductor memory as claimed in any one of the preceding claims, wherein said decoding means, (30, 32, 35) further comprises:
a column decoding means (35), responsive to said addressing means, coupled to the plurality of bit lines (12) for selectively applying predetermined voltages to said bit lines (12).

12. A programmable semiconductor memory according to claim 11, wherein said addressing means includes:
at least one temporary storage cell (41) coupled to a bit line (12), said temporary storage cells (41) being controlled by address data to select one of the temporary storage cells (41) for reading data from the associated memory cells or writing data into the associated memory cells (11).

13. A programmable semiconductor memory according to claim 11, wherein:
each circuit unit (10) comprises eight memory cells (11).

14. A programmable semiconductor memory according to any preceding claim, wherein:
said row decoding means (31, 32) sequentially applies a first predetermined voltage to the control gate of an addressed non-volatile transistor which is higher than the threshold voltage of that one of the non-volatile transistors to which low level data has been written and lower than the threshold voltage of that one of the non-volatile transistors to which high level data has been written in order to read sequentially data from said plurality of memory cells.

15. A programmable semiconductor memory according to claim 14, wherein:
said row decoding means (31, 32) applies a second predetermined voltage to the control gates of the non-addressed non-volatile transistors which are not currently being read which is higher than the threshold voltage of one of the non-volatile transistors to which high level data has been written.

16. A programmable semiconductor memory according to Claim 1 or 2, comprising:
first (12) and second (13) power source terminals, the first power source terminals (12) constituting the bit lines (12) and the second power source terminals (13) comprising ground lines (13).

17. A programmable semiconductor memory according to claim 14 in which the plurality of memory cells (11) connected in series comprises 2ⁿ memory cells, where n is an integer greater than or equal to 1.

18. A programmable semiconductor memory according to any preceding claim, wherein:
said decoding means (30, 32, 35) drives an addressed non-volatile transistor to its saturation state by applying a first predetermined voltage to its control gate and drives the remaining non-addressed non-volatile transistors to their non-saturation state by applying a second predetermined voltage to their control gates in order sequentially to write data to said plurality of memory cells (11).

19. A programmable semiconductor memory according to Claim 3 and any one of claims 16 to 18, wherein:
the erase gate electrodes (26) of the plurality of memory cells are coupled together.

20. A programmable semiconductor memory according to claim 18, wherein:
said decoding means (30, 32, 35) applies a predetermined voltage to the erase gates of the non-volatile transistors in order to erase data from said plurality of memory cells (11).

21. A programmable semiconductor memory according to claim 18, wherein:
said decoding means (30, 32, 35) sequentially applies a first predetermined voltage to the control gate of an addressed non-volatile transistor (16) which is higher than the threshold voltage of one of the non-volatile transistors to which low level data has been written and lower than the threshold voltage of one of the non-volatile transistors to which high level data has been written, and applies a second predetermined voltage to the control gates of the remaining non-addressed non-volatile transistors which is higher than the threshold voltage of one of the non-volatile transistors to which high level data has been written in order sequentially to read data from said plurality of memory cells (11).

## Patentansprüche

1. Programmierbarer Halbleiterspeicher, aufweisend:
eine Vielzahl von Schaltungseinheiten (10), die in einer Zeilen- und Spaltenmatrix angeordnet sind, wobei jede Schaltungseinheit (10) eine Vielzahl von in Serie geschalteten Speicherzellen (11) aufweist, und jede Speicherzelle (11) einen nichtflüchtigen Transistor aufweist;
eine Vielzahl von Bitleitungen (12₁ bis 12_{N}), die so angeordnet sind; daß ein Ende jeder Schaltungseinheit (10) mit einer der Bitleitungen gekoppelt ist, und die Schaltungseinheiten in einer bestimmten Spalte der Matrix mit derselben Bitleitung gekoppelt sind:
eine Vielzahl von Zeilenleitungen (14₁ bis 14_{M}), die so angeordnet sind, daß die Speicherzellen in einer bestimmten Schaltungseinheit über ihre Gates mit verschiedenen Zeilenleitungen gekoppelt sind, und die jeweiligen Speicherzellen in den mit verschiedenen Bitleitungen gekoppelten Speicherzellen über ihre Gates mit derselben Zeilenleitung gekoppelt sind;
Adressiermittel, die mit den Speicherzellen (11) gekoppelt sind, um in sequentieller Weise Adreßdaten an die Speicherzellen (11) zu übermitteln; und
auf die Adreßdaten ansprechende Dekodiermittel (30, 32, 35), um eine Speicherzelle (11) in einer der Schaltungseinheiten (10) auszuwählen, wozu Spannungen auf die Zeilenleitungen (14) und die Bitleitungen (12) gegeben werden, wobei die Dekodiermittel auf die Adreßdaten ansprechende Zeilendekodiermittel (31, 32) umfassen, um eine erste Spannung auf die Zeilenleitung (14) zu geben, die mit der ausgewählten Zelle (11) der einen der Schaltungseinheiten (10) gekoppelt ist, und eine zweite Spannung, die verschieden von der ersten Spannung ist, auf die Zeilenleitungen zu geben, die mit den nichtausgewählten Speicherzellen (11) der einen der Schaltungseinheiten (10) gekoppelt sind, dadurch gekennzeichnet, daß die Zeilendekodiermittel (31) eine Erdspannung, die verschieden von der ersten und zweiten Spannung ist, auf alle anderen Zeilenleitungen (14) geben.

2. Programmierbarer Halbleiterspeicher gemäß Anspruch 1, bei dem der Transistor jeder Speicherzelle (11) eine Floating-Gate-Elektrode (24), eine Steuergate-Elektrode (25), und eine Löschgate-Elektrode (26) hat.

3. Programmierbarer Halbleiterspeicher gemäß Anspruch 2, bei dem die Löschgate-Elektroden (26) der Speicherzellen (11) bei einer bestimmten Schaltungseinheit (10) zusammengekoppelt sind, wobei der Speicher weiterhin eine Vielzahl von Löschleitungen (15) aufweist, wobei die gekoppelten Löschgate-Elektroden (26) jeder Schaltungseinheit (10) bei einer bestimmten Spalte von Schaltungseinheiten (10) mit derselben Löschleitung (15) gekoppelt sind.

4. Programmierbarer Halbleiterspeicher gemäß Anspruch 3, der weiterhin Schaltmittel (16) aufweist, die zwischen den gekoppelten Löschgate-Elektroden (26) jeder Schaltungseinheit (10) und der entsprechenden Löschleitung (15) angeschlossen sind, um eine selektive Durchlaßsteuerung auszuführen.

5. Programmierbarer Halbleiterspeicher gemäß Anspruch 4, wobei die Dekodiermittel (30, 32, 35) auf die Adressiermittel ansprechen, um vorgegebene Spannungen in selektiver Weise auf die Vielzahl von Löschleitungen (15) zu geben, damit Daten in den Speicherzellen (11) gelöscht werden.

6. Programmierbarer Halbleiterspeicher gemäß Anspruch 4 oder Anspruch 5, wobei die Schaltmittel (16) einen Schalttransistor (16) aufweisen.

7. Programmierbarer Halbleiterspeicher gemäß Anspruch 6, weiterhin aufweisend:
eine Vielzahl von Löschauswahlleitungen (17), wobei die Steuergate-Elektroden (25) der Schalttransistoren, die den in derselben Zeile angeordneten Schaltungseinheiten entsprechen, mit derselben Löschauswahlleitung (17) gekoppelt sind.

8. Programmierbarer Halbleiterspeicher gemäß Anspruch 7, wobei:
die Dekodiermittel (30, 32, 35) eine erste vorgegebene Spannung auf eine adressierte Löschleitung (15), und eine zweite vorgegebene Spannung auf eine adressierte Löschauswahlleitung (17) geben, wobei die zweite vorgegebene Spannung die mit der adressierten Löschauswahlleitung (17) gekoppelten Schalttransistoren aktiviert, so daß durch Anlegen der ersten vorgegebenen Spannung an die gekoppelten Löschgate-Elektroden (26) einer bestimmten Schaltungseinheit (10) eine Datenlöschung in dieser Serienschaltungseinheit (10) erfolgt.

9. Programmierbarer Halbleiterspeicher gemäß Anspruch 7, wobei;
die Dekodiermittel (30, 32, 35) eine erste vorgegebene Spannung auf eine adressierte Löschleitung (15), und eine zweite vorgegebene Spannung auf jede der Vielzahl von Löschauswahlleitungen (17) geben, wobei die zweite vorgegebene Spannung die mit den Löschauswahlleitungen (17) gekoppelten Schalttransistoren aktiviert, so daß durch Anlegen der ersten vorgegebenen Spannung an die gekoppelten Löschgate-Elektroden (26) jeder Schaltungseinheit (10) in einer bestimmten Spalte eine Datenlöschung in dieser Spalte von Serienschaltungseinheiten (10) erfolgt, die sowohl mit der addressierten Löschleitung (15), als auch den aktivierten Schalttransistoren gekoppelt ist.

10. Programmierbarer Halbleiterspeicher gemäß Anspruch 7, wobei:
die Dekodiermittel (30, 32, 35) eine erste vorgegebene Spannung auf jede der Vielzahl von Löschleitungen (15), und eine zweite vorgegebene Spannung auf jede der Vielzahl von Löschauswahlleitungen (17) geben, wobei die zweite vorgegebene Spannung die mit den Löschauswahlleitungen (17) gekoppelten Schalttransistoren aktiviert, so daß durch Anlegen der ersten vorgegebenen Spannung an die gekoppelten Löschgate-Elektroden (16) der Schaltungseinheiten (10) eine Datenlöschung in jeder Schaltungseinheit (10) erfolgt.

11. Programmierbarer Halbleiterspeicher gemäß irgendeinem der vorhergehenden Ansprüche, wobei die Dekodiermittel (30, 32, 35) weiterhin aufweisen:
ein auf die Adressiermittel ansprechendes, mit der Vielzahl von Bitleitungen (12) gekoppeltes Spaltendekodiermittel (35), um vorgegebene Spannungen in selektiver Weise auf die Bitleitungen (12) zu geben.

12. Programmierbarer Halbleiterspeicher gemäß Anspruch 11, wobei die Adressiermittel umfassen:
mindestens eine Zwischenspeicherungszelle (41), die mit einer Bitleitung (12) gekoppelt ist, wobei die Zwischenspeicherungszellen (41) durch Adreßdaten gesteuert werden, um eine der Zwischenspeicherungszellen (41) auszuwählen, so daß Daten aus den zugeordneten Speicherzellen ausgelesen werden können, oder Daten in die zugeordneten Speicherzellen (11) eingeschrieben werden können.

13. Programmierbarer Halbleiterspeicher gemäß Anspruch 11, wobei:
jede Schaltungseinheit (10) acht Speicherzellen (11) aufweist.

14. Programmierbarer Halbleiterspeicher gemäß irgendeinem vorhergehenden Anspruch, wobei:
die Zeilendekodiermittel (31, 32) eine erste vorgegebene Spannung in sequentieller Weise auf das Steuergate eines adressierten, nichtflüchtigen Transistors geben, die größer ist als die Schwellenspannung desjenigen der nichtflüchtigen Transistoren, in den Tiefpegeldaten eingeschrieben wurden, und kleiner ist als die Schwellenspannung desjenigen der nichtflüchtigen Transistoren, in den Hochpegel daten eingeschrieben wurden, um Daten in sequentieller Weise aus der Vielzahl von Speicherzellen auszulesen.

15. Programmierbarer Halbleiterspeicher gemäß Anspruch 14, wobei :
die Zeilendekodiermittel (31, 32) eine zweite vorgegebene Spannung auf die Steuergates der nichtadressierten, nichtflüchtigen Transistoren, die gegenwärtig nicht gelesen werden, geben, die größer ist als die Schwellenspannung von einem der nichtflüchtigen Transistoren, in den Hochpegeldaten eingeschrieben wurden.

16. Programmierbarer Halbleiterspeicher gemäß Anspruch 1 oder 2, aufweisend:
erste (12) und zweite (13) Stomquellen-Klemmen, wobei die ersten Stromquellen-Klemmen (12) die Bitleitungen (12) darstellen, und die zweiten Stromquellen-Klemmen (13) die Erdleitungen (13) darstellen.

17. Programmierbarer Halbleiterspeicher gemäß Anspruch 14, bei dem die Vielzahl von in Serie geschalteten Speicherzellen (11) 2ⁿ Speicherzellen aufweist, wobei n eine ganze Zahl größer als, oder gleich 1 ist.

18. Programmierbarer Halbleiterspeicher gemäß irgendeinem vorhergehenden Anspruch, wobei:
die Dekodiermittel (30, 32, 35) einen adressierten, nichtflüchtigen Transistor durch Anlegen einer ersten vorgegebenen Spannung an sein Steuergate in seinen Sättigungszustand steuern, und die verbleibenden, nichtadressierten, nichtflüchtigen Transistoren durch Anlegen einer zweiten vorgegebenen Spannung an ihre Steuergates in ihren Nicht-Sättigungszustand steuern, um Daten in sequentieller Weise in die Vielzahl von Speicherzellen (11) einzuschreiben.

19. Programmierbarer Halbleiterspeicher gemäß Anspruch 3 und irgendeinem der Ansprüche 16 bis 18, wobei:
die Löschgate-Elektroden (26) der Vielzahl von Speicherzellen zusammengekoppelt sind.

20. Programmierbarer Halbleiterspeicher gemäß Anspruch 18, wobei :
die Dekodiermittel (30, 32, 35) eine vongegebere Spannung auf die Löschgates der nichtflüchtigen Transistoren geben, um die Daten in der Vielzahl von Speicherzellen (11) zu löschen.

21. Programmierbarer Halbleiterspeicher gemäß Anspruch 18. wobei:
die Dekodiermittel (30, 32, 35) eine erste vorgegebene Spannung in sequentieller Weise auf das Steuergate eines adressienten, nichtflüchtigen Transistors (16) geben, die größer ist als die Schwellenspannung von einem der nichtflüchtigen Transistoren, in den Tiefpegeldaten eingeschrieben wurden, und kleiner ist als die Schwellenspannung von einem der nichtflüchtigen transistoren, in den Hochpegeldaten eingeschrieben wurden, und eine zweite vorgegebene Spannung auf die Steuergates der verbleibenden, nichtadressierten, nichtflüchtigen Transistoren geben, die größer ist als die Schwellenspannung von einem der nichtflüchtigen Transistoren, in den Hochpegeldaten eingeschrieben wurden, um Daten in sequentieller Weise aus der Vielzahl von Speicherzellen (11) auszulesen.

## Revendications

1. Mémoire à semiconducteurs programmable comprenant:
un ensemble d'unités de circuits (10) disposées en une matrice de lignes et de colonnes, chaque unité de circuit (10) comprenant un ensemble de cellules de mémoire (11) connectées en série, et chaque cellule de mémoire (11) comprenant un transistor non volatil;
un ensemble de lignes de bit (12₁ à 12_{N}) disposées de façon qu'une extrémité de chaque unité de circuit (10) soit couplée à l'une des lignes de bit, et que les unités de circuit dans une colonne donnée de la matrice soient couplées à la même ligne de bit;
un ensemble de lignes de rangée (14₁ à 14_{M}) disposées de façon que des cellules de mémoire dans une unité de circuit donnée soient couplées par leurs grilles à des lignes de rangée différentes, et que les cellules de mémoire respectives dans les unités de circuit couplées à des lignes de bit différentes soient couplées par leurs grilles à la même ligne de rangée;
des moyens d'adressage couplés aux cellules de mémoire (11) pour appliquer séquentiellement des données d'adresse aux cellules de mémoire (11); et
des moyens de décodage (30, 32, 35) réagissant aux données d'adresse de façon à sélectionner une cellule de mémoire (11) dans l'une des unités de circuit (10) par l'application de tensions aux lignes de rangée (14) et aux lignes de bit (12), ces moyens de décodage comprenant des moyens de décodage de rangée (31, 32) qui réagissent aux données d'adresse en appliquant une première tension à la ligne de rangée (14) qui est couplée à la cellule sélectionnée (11) de l'unité de circuit (10) précitée, et une seconde tension, différente de la première tension, aux lignes de rangée qui sont couplées aux cellules de mémoire (11) non sélectionnées de l'unité de circuit (10) précitée, caractérisée en ce que les moyens de décodage de rangée (31) appliquent une tension de masse, différente des première et seconde tensions, à toutes les autres lignes de rangée (14).

2. Mémoire à semiconducteurs programmable selon la revendication 1, dans laquelle le transistor de chaque cellule de mémoire (11) a une électrode de grille flottante (24), une électrode de grille de commande (25) et une électrode de grille d'effacement (26).

3. Mémoire à semiconducteurs programmable selon la revendication 2, dans laquelle les électrodes de grille d'effacement (26) des cellules de mémoire (11) dans une unité de circuit (10) donnée sont couplées ensemble, cette mémoire comprenant en outre un ensemble de lignes d'effacement (15), avec une configuration dans laquelle les électrodes de grille d'effacement (26) couplées de chaque unité de circuit (10) dans une colonne donnée d'unités de circuit (10) sont couplées à la même ligne d'effacement (15).

4. Mémoire à semiconducteurs programmable selon la revendication 3, comprenant en outre des moyens de commutation (16) connectés entre les électrodes de grille d'effacement (26) couplées de chaque unité de circuit (10) et la ligne d'effacement (15) correspondante, pour effectuer une commande de conduction sélective.

5. Mémoire à semiconducteurs programmable selon la revendication 4, dans laquelle les moyens de décodage (30, 32, 35) réagissent aux moyens d'adressage en appliquant sélectivement des tensions prédéterminées à l'ensemble de lignes d'effacement (15), afin d'effacer des données dans les cellules de mémoire (11).

6. Mémoire à semiconducteurs programmable selon la revendication 4 ou la revendication 5, dans laquelle les moyens de communication (16) comprennent un transistor de commutation (16).

7. Mémoire à semiconducteurs programmable selon la revendication 6, comprenant en outre :
un ensemble de lignes de sélection d'effacement (17), les électrodes de grille de commande (25) des transistors de commutation correspondant aux unités de circuit qui sont disposées dans la même rangée étant couplées à la même ligne de sélection d'effacement (17).

8. Mémoire à semiconducteurs programable selon la revendication 7, dans laquelle:
les moyens de décodage (30, 32, 35) appliquent une première tension prédéterminée à une ligne d'effacement (15) adressée et une seconde tension prédéterminée à une ligne de selection d'effacement (17) adressée, cette seconde tension prédéterminée activant les transistors de commutation qui sont couplés à la ligne de sélection d'effacement (17) adressée, de façon à effectuer un effacement des données dans une unité de circuit série (10) particulière, par l'application de la première tension prédéterminée aux électrodes de grille d'effacement (26) couplées de l'unité de circuit (10) particulière.

9. Mémoire à semiconducteurs programmable selon la revendication 7, dans laquelle:
les moyens de décodage (30, 32, 35) appliquent une première tension prédéterminée à une ligne d'effacement (15) adressée et une seconde tension prédéterminée à chaque ligne parmi un ensemble de lignes de sélection d'effacement (17), cette seconde tension prédéterminée activant les transistors de commutation qui sont couplés aux lignes de sélection d'effacement (17), de façon à effectuer l'effacement des données dans la colonne particulière d'unités de circuit série (10) qui sont couplées à la fois à la ligne d'effacement (15) adressée et aux transistors de ccmmutation activés, par l'application de la première tension prédéterminée aux électrodes de grille d'effacement (26) couplées de chaque unité de circuit (10) dans cette colonne particulière (10).

10. Mémoire à semiconducteurs programmable selon la revendication 7, dans laquelle:
les moyens de décodage (30, 32, 35) appliquent une première tension prédéterminée à chaque ligne de l'ensemble de lignes d'effacement (15) et une seconde tension prédéterminée à chaque ligne de l'ensemble de lignes de sélection d'effacement (17), cette seconde tension prédéterminée activant les transistors de commutation qui sont couplés aux lignes de sélection d'effacement (17), de façon à effectuer l'effacement des données dans chaque unité de circuit (10), par l'application de la première tension prédéterminée aux électrodes de grille d'effacement (16) couplées des unités de circuit (10).

11. Mémoire à semiconducteurs programmable selon l'une quelconque des revendications précédentes, dans laquelle les moyens de décodage (30, 32, 35) comprennent en outre:
des moyens de décodage de colonne (35), réagissant aux moyens d'adressage, qui sont couplés à l'ensemble de lignes de bit (12), pour appliquer sélectivement des tensions prédéterminées à ces lignes de bit (12).

12. Mémoire à semiconducteurs programmable selon la revendication 11, dans laquelle les moyens d'adressage comprennent:
au moins une cellule d'enregistrement temporaire (41) couplée à une ligne de bit (12), ces cellules d'enregistrement temporaire(41) étant commandées par des données d'adresse de façon à sélectionner l'une des cellules d'enregistrement temporaire (41) pour lire des données dans les cellules de mémoire associées, ou pour écrire des données dans les cellules de mémoire associées (11).

13. Mémoire à semiconducteurs programmable selon la revendication 11, dans laquelle:
chaque unité de circuit (10) comprend huit cellules de mémoire (11).

14. Mémoire à semiconducteurs programmable selon l'une quelconque des revendications précédentes, dans laquelle:
les moyens de décodage de rangée (31, 32) appliquent séquentiellement à la grille de commande d'un transistor non volatil adressé une première tension prédéterminée qui est supérieure à la tension de seuil de celui des transistors non volatils dans lequel des données de niveau bas ont été écrites, et qui est inférieure à la tension de seuil de celui des transistors non volatils dans lequel des données de niveau haut ont été écrites, afin de lire séquentiellement des données dans l'ensemble de cellules de mémoire.

15. Mémoire à semiconducteurs programmable selon la revendication 14, dans laquelle:
les moyens de décodage de rangée (31, 32) appliquent aux grilles de commande des transistors non volatils non adressés, qui ne font pas l'objet d'une opération de lecture au moment présent, une seconde tension prédéterminée qui est supérieure à la tension de seuil de l'un des transistors non volatils dans lequel des données de niveau haut ont été écrites.

16. Mémoire à semiconducteurs programmable selon la revendication 1 ou 2, comprenant:
des premières (12) et secondes (13) bornes de source d'alimentation, les premières bornes de source d'alimentation (12) constituant les lignes de bit (12) et les secondes bornes de source d'alimentation (13) constituant des lignes de masse (13).

17. Mémoire à semiconducteurs programmable selon la revendication 14, dans laquelle l'ensemble de cellules de mémoires (11) connectées en série comprend 2ⁿ cellules de mémoire, en désignant par ⁿ un entier supérieur ou égal à 1.

18. Mémoire à semiconducteurs programmable selon l'une quelconque des revendications précédentes, dans laquelle:
les moyens de décodage (30, 32, 35) font passer un transistor non volatil adressé dans son état de saturation en appliquant une première tension prédéterminée à sa grille de commande, et ils font passer les transistors non volatils non adressés restants dans leur état de non-saturation, en appliquant une seconde tension prédéterminée à leurs grilles de commande, pour écrire séquentiellement des données dans l'ensemble de cellules de mémoire (11).

19. Mémoire à semiconducteurs programmable selon la revendication 3 et l'une quelconque des revendications 16 à 18, dans laquelle:
les électrodes de grille d'effacement (26) de l'ensemble de cellules de mémoire sont couplées ensemble.

20. Mémoire à semiconducteurs programmable selon la revendication 18, dans laquelle:
les moyens de décodage (30, 32, 35) appliquent une tension prédéterminée aux grilles d'effacement des transistors non volatils de façon à effacer des données dans l'ensemble de cellules de mémoire (11).

21. Mémoire à semiconducteurs programmable selon la revendication 18, dans laquelle:
les moyens de décodage (30, 32, 35) appliquent séquentiellement à la grille de commande d'un transistor non volatil (16) adressé une première tension prédéterminée qui est supérieure à la tension de seuil de l'un des transistors non volatils dans lequel des données de niveau bas ont été écrites, et qui est inférieure à la tension de seuil de l'un des transistors non volatils dans lequel des données de niveau haut ont été écrites, et ils appliquent aux grilles de commande des transistors non volatils non adressés restants une seconde tension prédéterminée qui est supérieure à la tension de seuil de l'un des transistors non volatils dans lequel des données de niveau haut ont été écrites, pour lire séquentiellenent des données dans l'ensemble de cellules de mémoire (11).
